# EUROPÄISCHE PATENTSCHRIFT

(11) **EP 3 596 822 B1**
(45) Veröffentlichungstag und Bekanntmachung des Hinweises auf die Patenterteilung: **26.11.2025**
(21) Anmeldenummer: 18711926.8
(22) Anmeldetag: 16.03.2018
(51) Int. Cl.: H03F 3/181, H04R 1/10, H04R 3/00, H04R 19/00

(54) **VERSTÄRKEREINHEIT FÜR EINEN SCHALLWANDLER UND SCHALLERZEUGUNGSEINHEIT**
AMPLIFIER FOR SOUND TRANSDUCER
AMPLIFICATEUR POUR UN TRANSDUCTEUR ACOUSTIQUE

(30) Priorität: 16.03.2017 DE 102017105594
(43) Veröffentlichungstag der Anmeldung: 22.01.2020
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); HAENSLER, Markus, 8081 Heiligenkreuz am Waasen (AT)
(74) Vertreter: Canzler & Bergmeier Patentanwälte Partnerschaft mbB
(86) Internationale Anmeldenummer: PCT/EP2018/056668
(87) Internationale Veröffentlichungsnummer: WO 2018/167272

(56) Entgegenhaltungen:
- DE-A1- 102007 057 664
- DE-U1- 202009 009 804
- US-A1- 2006 034 472
- US-A1- 2008 170 515

## Beschreibung

Die vorliegende Erfindung betrifft eine Verstärkereinheit für einen Schallwandler, insbesondere einen MEMS-Schallwandler, der als Mikrofon und als Lautsprecher betreibbar ist, mit zumindest einem Audioverstärker zur Schallwiedergabe und/oder Schallaufnahme. Des Weiteren betrifft die Erfindung eine Schallerzeugungseinheit mit einem Schallwandler, insbesondere einen MEMS-Schallwandler, der als Mikrofon und als Lautsprecher betreibbar ist, und einer mit dem Schallwandler gekoppelten Verstärkereinheit zur Schallwiedergabe und/oder Schallaufnahme.

Im Stand der Technik sind Vorrichtungen und Verfahren zur Lärmunterdrückung, sogenannte "active noise reduction" - ANR-Verfahren oder "active noise cancelling" - ANC-Verfahren bekannt. Derartige Vorrichtungen sind beispielsweise in Kopfhörern oder Headsets angeordnet, wobei zur Lärmunterdrückung störende Umgebungsgeräusche dadurch vermindert werden, dass diese zuerst von einem am Kopfhörer angeordneten Mikrofon aufgenommen werden. Aus dem aufgenommenen Schallsignal wird durch die Vorrichtung ein zu den Umgebungsgeräuschen passender Antischall erzeugt, der von einem Lautsprecher des Kopfhörers zusätzlich zur Musik abgespielt wird. Der Antischall und die Umgebungsgeräusche löschen sich durch destruktive Interferenz gegenseitig aus, so dass lediglich die Musik und insbesondere keine Umgebungsgeräusche den Träger des Kopfhörers erreicht.

Aus der US 2016/0182987 A1 ist ein Gerät mit einem Mikrofon und mit einer Treiberanordnung bekannt. Das Gerät umfasst einen Mikrofon- und einen Lautsprechertreiber, die einen Schallwandler betreiben, wobei dieser als Mi-krofon und als Lautsprecher genutzt werden kann. Nachteilig bei diesem Gerät ist es, dass damit ein ANR-Verfahren nicht durchgeführt werden kann.

In der US 2006/0034472 A1 ist eine Schaltung offenbart, die ein MEMS-Mikrofon oder einen MEMS-Lautsprecher betreiben kann.

In der US 2008/0170515 A1 ist eine Schaltung zum Betreiben eines Einzelschallwandlers beschrieben.

Aufgabe der vorliegenden Erfindung ist es somit, eine Vorrichtung zu schaffen, mit der Umgebungsgeräusche effektiv unterdrückt werden können.

Die Aufgabe wird gelöst durch eine Schallerzeugungseinheit mit den Merkmalen des unabhängigen Patentanspruchs.

Vorgeschlagen wird ein MEMS-Schallwandler, der als Mikrofon und als Lautsprecher betreibbar ist und der an eine Verstärkereinheit gekoppelt ist. Die Verstärkereinheit ist somit eine MEMS-Verstärkereinheit oder eine MEMS-Schallwandler-Verstärkereinheit. Der MEMS-Schallwandler kann im Folgenden der Einfachheit halber als Schallwandler bezeichnet werden.

Die Verstärkereinheit kann beispielsweise dafür genutzt werden, um ein "active noise reduction"-Verfahren (ANR-Verfahren) oder eine aktive Kompensation für Umgebungsgeräusche durchzuführen. Der Schallwandler sowie die Verstärkereinheit, die den Schallwandler betreibt, ist beispielsweise in einem Kopfhörer, Headset, In-Ear-Kopfhörer, Helm mit Kopfhörer oder Mobiltelefon angeordnet, um dem Träger bzw. dem Benutzer eine höhere Qualität der Musik, des Tons und/oder der Sprache bereitzustellen, indem mit Hilfe der Verstärkereinheit die Umgebungsgeräusche vermindert werden. Bei dem ANR-Verfahren werden die Umgebungsgeräusche beispielsweise mit Hilfe eines Antischalls ausgelöscht. Die aktive Kompensation kann sich dadurch auszeichnen, dass die Umgebungsgeräusche mittels des Antischalls ausgelöscht werden. Eine passive Kompensation von Umgebungsgeräuschen könnte beispielsweise durch eine Schallisolation des Kopfhörers ausgebildet sein.

Ferner umfasst die Verstärkereinheit zumindest einen Audioverstärker zur Schallwiedergabe und/oder zur Schallaufnahme. Der Audioverstärker kann beispielsweise die durch den Schallwandler aufgenommenen Schallsignale verarbeiten und/oder aufbereiten, wenn dieser als Mikrofon betrieben wird. Beispielsweise kann der Audioverstärker die Schallsignale derart verarbeiten, dass sie digital abgespeichert werden können.

Mit Hilfe des Audioverstärkers können beispielsweise auch in die Verstärkereinheit eingehende Audiosignale verarbeitet werden, wenn der Schallwandler als Lautsprecher betrieben wird. Der Audioverstärker kann dabei die Audiosignale derart verarbeiten und/oder aufbereiten, dass diese vom Schallwandler in Schallwellen, beispielsweise Töne, Musik und/oder Sprache, umgesetzt werden können.

Erfindungsgemäß ist die Verstärkereinheit derart ausgebildet, dass der dafür vorgesehene Schallwandler simultan als Lautsprecher und als Mikrofon betreibbar ist. Dabei kann das simultane Betreiben des Schallwandlers als Lautsprecher und als Mikrofon beispielsweise bedeuten, dass ein Träger des Kopfhörers, in dem die Verstärkereinheit angeordnet ist, den Eindruck erhält, der Schallwandler kann simultan Schall als Lautsprecher wiedergeben und Schall als Mikrofon aufnehmen.

Wie oben beschrieben, werden beim "active noise reduction"-Verfahren die Umgebungsgeräusche von einem Mikrofon aufgenommen. Daraus wird der Antischall erzeugt, der, vorzugsweise zeitgleich, mit der Musik von einem Lautsprecher im Kopfhörer ausgegeben wird. Der Antischallteil der Musik interferiert mit den Umgebungsgeräuschen und löscht diese aus. Übrig bleibt die Musik, wobei der Benutzer die Umgebungsgeräusche nicht hört. Insbesondere können mit Hilfe des Schallwandlers die Umgebungsgeräusche aufgenommen und gleichzeitig dazu der entsprechende Antischall mit der Musik abgespielt werden. Die Umgebungsgeräusche und der Antischall löschen sich gegenseitig durch destruktive Interferenz aus, so dass lediglich die Musik übrig bleibt.

Durch das simultane Betreiben des Schallwandlers als Mikrofon und Lautsprechen kann vorteilhafterweise auf ein Mikrofon zum Aufnehmen der Umgebungsgeräusche oder den Lautsprecher zum Ausgeben lediglich des Antischalls verzichtet werden, da der Schallwandler der erfindungsgemäßen Verstärkereinheit simultan die Umgebungsgeräusche aufnimmt und den dazu passenden Antischall zusätzlich zur Musik abspielt. Dadurch kann das ANR-Verfahren nur noch mit einem Schallwandler durchgeführt werden, so dass der Kopfhörer günstiger hergestellt werden kann. Durch die Aufnahme des Schalls, insbesondere der Umgebungsgeräusche, und der Wiedergabe der Musik durch den Schallwandler an einem Ort wird die Klangqualität erhöht. Durch einen Schallwandler als Lautsprecher und Mikrofon wird der Antischall an dem Ort erzeugt, an dem die dazugehörigen Umgebungsgeräusche herrschen, so dass der Antischall genau auf die dazugehörigen Umgebungsgeräusche abgestimmt ist.

Außerdem kann eine Geschwindigkeit des ANR-Verfahrens schneller durchgeführt werden, da eine Laufzeit des Schalls zwischen dem Ort der Aufnahme der Umgebungsgeräusche und dem Ort der Wiedergabe des Antischalls nicht mit einberechnet werden muss.

In einer vorteilhaften Weiterbildung der Erfindung weist die Verstärkereinheit einen Prozessor auf, mittels dem der dafür vorgesehene Schallwandler während der Schallerzeugung zeitgleich als Mikrofon genutzt werden kann. Der Prozessor kann auch als digitaler Signalprozessor ausgebildet sein. Der Prozessor kann beispielsweise eine Recheneinheit umfassen, in der ein Computerprogramm ausgeführt wird, das die Umgebungsgeräusche aus dem aufgenommenen Schallsignal herausfiltert und daraus den Antischall erzeugt. Der Prozessor kann auch den zumindest einen Audioverstärker betreiben. Vorteilhafterweise kann der Prozessor den Antischall an den Audioverstärker leiten, der zur Schallwiedergabe mit dem Schallwandler verbunden ist, um den Antischall, vorzugsweise mit der Musik, abzuspielen.

Ebenfalls ist es von Vorteil, wenn der Prozessor zur Geräuschunterdrückung derart ausgebildet ist, dass dieser anhand des ausgesendeten Audiosignals und dem zeitgleich mit demselben Schallwandler erfassten Schallsignal Umgebungsgeräusche herausfiltern und/oder unterdrücken kann. Der Prozessor bildet aus den Umgebungsgeräuschen den Antischall und führt diesen wieder an den Schallwandler zurück, der als Lautsprecher den Antischall zusammen mit der Musik abgibt.

Von Vorteil ist es, wenn der Prozessor derart ausgebildet ist, dass dieser ein Schallsignal, das vom als Mikrofon arbeitenden MEMS-Schallwandler erfasst wird, in einem die ausgesendeten Nutzgeräusche repräsentierenden ersten Schallsignalanteil und einen die Umgebungsgeräusche repräsentierenden zweiten Schallsignalteil trennt. Die Nutzgeräusche enthalten beispielsweise Musik, Ton und Sprache, welche für einen Hörer bereitgestellt werden sollen. Die Umgebungsgeräusche sind dagegen Störgeräusche. Dadurch können die Umgebungsgeräusche weiterverarbeitet werden. Aus den Umgebungsgeräuschen kann dadurch der Antischall erzeugt werden, der die Umgebungsgeräusche auslöscht.

Vorteilhafterweise können die Umgebungsgeräusche aus dem erfassten Schallsignal herausgefiltert bzw. von diesen getrennt werden, indem ein Differenzsignal gebildet wird. Da bei gleichzeitigem Betrieb des Schallwandlers als Lautsprecher und als Mikrofon die mittels des Schallwandlers als Mikrofon erfassten Schallsignale die Umgebungsgeräusche und die Nutzgeräusche enthält, können durch Differenzbildung die Umgebungsgeräusche vom erfassten Schallsignal getrennt werden. Die Nutzgeräusche sind dabei bekannt, da diese dem durch den Lautsprecher erzeugten Audiosignal entsprechen. Das erfasste Schallsignal enthält somit einen ersten Schallsignalanteil, der von den gemäß dem Audiosignal erzeugten Schallwellen herrührt bzw. die Nutzgeräusche umfasst, und einen zweiten Schallsignalanteil, der von den Umgebungsgeräuschen herrührt. Beispielsweise kann der erste Schallsignalanteil aus dem Schallsignal herausgefiltert bzw. abgetrennt, insbesondere von diesem abgezogen werden, so dass noch der zweite Schallsignalanteil, der die Umgebungsgeräusche umfasst, übrig bleibt. Ein Vorteil davon ist, dass der erste Schallsignalanteil bekannt ist, da dieser dem Audiosignal entspricht, gemäß dem die Schallwellen, welche wiederum zumindest Musik, Töne und Sprache enthalten, erzeugt werden.

Außerdem ist es von Vorteil, wenn der Prozessor derart ausgebildet ist, dass dieser anhand des zweiten Schallsignalanteils ein Antischallsignal erzeugt und dieses mit einem Nutzgeräusch umfassenden Eingangssignal zum Audiosignal zusammenfasst. Das Eingangssignal kann beispielsweise die Sprache, die Musik oder die Töne umfassen. Das Eingangssignal kann beispielsweise von einer Musikdatei stammen. Der Prozessor kann ferner das Antischallsignal erzeugen, dass die Umgebungsgeräusche auslöscht, wenn daraus Schallwellen erzeugt werden. Ferner kann der Prozessor das Antischallsignal und das Eingangssignal zum Audiosignal zusammenfassen, welches dem MEMS-Schallwandler geschickt wird, welcher entsprechende Schallwellen erzeugt. Diese enthalten dann die Nutzgeräusche, welche die Musik, die Töne oder die Sprache umfassen, und den Antischall, der die Umgebungsgeräusche auslöscht.

Ferner ist es vorteilhaft, wenn der Prozessor derart ausgebildet ist, dass dieser den MEMS-Schallwandler zwischen dem Betrieb als Lautsprecher und dem Betrieb als Mikrofon umschalten kann. Der Prozessor kann dazu beispielsweise eine Schalteinheit aufweisen, die den Schallwandler zwischen dem Betrieb als Lautsprecher und dem Betrieb als Mikrofon umschalten kann. Schaltet der Prozessor ausreichend schnell zwischen dem Betrieb des Schallwandlers als Lautsprecher und dem Betrieb als Mikrofon um, kann dies für eine Person den Eindruck erwecken, dass der Schallwandler gleichzeitig bzw. simultan als Lautsprecher und als Mikrofon betrieben wird. Beispielsweise kann in einem Lautsprecherintervall der Schallwandler als Lautsprecher und in einem Mikrofonintervall als Mikrofon betrieben werden. Das Lautsprecherintervall und das Mikrofonintervall können sich vorteilhafterweise abwechseln. Wechseln sich diese beiden Intervalle ausreichend schnell ab, kann dies empfunden werden, als ob der Schallwandler gleichzeitig die Schallwellen erzeugt und erfasst. Der Prozessor kann dabei zwischen dem Lautsprecherintervall und dem Mikrofonintervall umschalten.

Vorteilhaft ist es auch, wenn die Verstärkereinheit einen hybriden Audioverstärker aufweist, mittels dem zur Schallwiedergabe des Audiosignal an den dafür vorgesehenen Schallwandler ausgegeben und zur Schallaufnahme das Schallsignal des Schallwandlers empfangen werden kann. Der hybride Audioverstärker ist somit derart ausgebildet, dass dieser das Audiosignal an den Schallwandler schicken und zeitgleich das Schallsignal, das Musik und Umgebungsgeräusche enthält, von demselben Schallwandler empfangen kann. Der hybride Audioverstärker kann über eine einzige Audioleitung mit dem Schallwandler verbunden sein.

Ebenso ist es vorteilhaft, wenn die Verstärkereinheit einen Lautsprecherverstärker zur Schallwiedergabe des Audiosignals und einen Mikrofonverstärker zur Schallaufnahme des Schallsignals aufweist. Dadurch können die jeweils beiden Verstärker auf deren Aufgabe spezialisiert werden. Der Lautsprecherverstärker kann darauf optimiert werden, das Audiosignal zur Schallwiedergabe für den Schallwandler vorzubereiten. Der Mikrofonverstärker kann ebenfalls optimiert werden, um das vom Mikrofon aufgenommene Schallsignal zu verarbeiten. Da das Schallsignal die Musik und die Umgebungsgeräusche enthält, kann der Mikrofonverstärker dahingehend optimiert werden, dass er die Umgebungsgeräusche von der Musik trennt. Daraufhin können die Umgebungsgeräusche verarbeitet werden, um daraus den Antischall zu erzeugen. Die beiden Verstärker können dabei jeweils einzeln mittels Audioleitungen mit dem Schallwandler verbunden sein. Alternativ können die beiden von den Verstärkern kommenden Audioleitungen zuerst zusammengeführt werden, so dass nur noch eine Audioleitung zum Schallwandler führt.

Ferner ist es von Vorteil, wenn der Audioverstärker derart ausgebildet ist, dass mit diesem ein MEMS-Schallwandler betreibbar ist. Bei dem MEMS-Schallwandler kann es sich außerdem um einen piezoelektrischen MEMS-Schallwandler handeln. Der MEMS-Schallwandler kann besonders platzsparend ausgebildet werden und weist lediglich eine geringe Leistungsaufnahme auf, so dass beispielsweise ein batteriebetriebener Kopfhörer eine lange Laufzeit aufweist. Außerdem ist der MEMS-Schallwandler einfach mit elektrischen Signalen als Lautsprecher betreibbar. Ferner erzeugt insbesondere der piezoelektrische MEMS-Schallwandler als Mikrofon unmittelbar ein elektrisches Schallsignal, das direkt vom Audioverstärker verarbeitet werden kann.

Vorteilhaft ist es des Weiteren, wenn die Verstärkereinheit zumindest eine Signalverarbeitungseinheit aufweist, die mit dem zumindest einen Audioverstärker verbunden ist. Mittels der Signalverarbeitungseinheit ist das Audiosignal zur Schallwiedergabe vorbereitbar. Die Signalverarbeitungseinheit kann beispielsweise das Audiosignal filtern, vorverstärken und/oder modulieren, so dass es der Audioverstärker an den Schallwandler zur Schallwiedergabe leiten kann.

Zusätzlich oder alternativ ist mittels der Signalverarbeitungseinheit das Schallsignal zur Schallaufnahme aufbereitbar. Auch dazu kann die Signalverarbeitungseinheit das Schallsignal beispielsweise filtern, vorverstärken, modulieren, digitalisieren und/oder speichern. Die Signalverarbeitungseinheit kann beispielsweise auch derart ausgebildet sein, dass es die in dem Schallsignal enthaltenen Umgebungsgeräusche von der Musik trennt. Die Signalverarbeitungseinheit kann beispielsweise auch den zu den Umgebungsgeräuschen passenden Antischall erzeugen. Die Signalverarbeitungseinheit kann auch den Antischall dem Lautsprecherverstärker zuführen, so dass dieser zur Auslöschung der Umgebungsgeräusche die Musik mit dem Antischall abspielt.

Auch von Vorteil ist es, wenn der Prozessor eine Datenverbindung zu dem zumindest einen Audioverstärker aufweist. Zusätzlich oder alternativ kann der Prozessor auch eine Datenverbindung zu der zumindest einen Signalverarbeitungseinheit aufweisen. Über die Datenverbindung können dem Prozessor die ausgesendeten Audiosignale und die erfassten Schallsignale und die in der Signalverarbeitungseinheit zu verarbeitenden Audiodaten übermittelt werden. Die Datenverbindung kann außerdem als eine bidirektionale Datenverbindung ausgebildet sein, so dass Daten in beide Richtungen geleitet werden können.

Die Datenverbindung kann ferner auch als eine Leiterbahn einer Leiterplatine ausgebildet sein.

Vorteilhaft ist es ebenfalls, wenn die Verstärkereinheit zumindest eine Schnittstelle aufweist, über die vorzugsweise zeitgleich Audiosignale von der Verstärkereinheit an den Schallwandler und Schallsignale von diesem an die Verstärkereinheit übermittelt werden können. Die Schnittstelle kann ferner kabelgebunden und/oder bidirektional ausgebildet sein. Die Schnittstelle kann beispielsweise als ein Klinkenstecker, ein Cinchstecker, ein XLR-Stecker, eine Speakon-Steckverbindung und/oder eine USB-Verbindung ausgebildet sein. Durch eine derartige Schnittstelle kann der Schallwandler lösbar mit der Verstärkereinheit verbunden werden. Die Schnittstelle kann aber auch als eine Lötverbindung ausgebildet sein, so dass der Schallwandler fest mit der Verstärkereinheit verbunden ist.

Auch von Vorteil ist es, wenn die Verstärkereinheit auf einem einzigen Chip angeordnet ist. Dadurch kann die Verstärkereinheit mit dem Audioverstärker, der Signalverarbeitungseinheit, dem Prozessor und/oder den Datenverbindungen auf einem einzigen Chip angeordnet werden. Die Verstärkereinheit kann dann besonders platzsparend in einem ASIC angeordnet sein.

Des Weiteren wird eine Schallerzeugungseinheit mit einem Schallwandler, der als Mikrofon und als Lautsprecher betreibbar ist, vorgeschlagen. Die Schallerzeugungseinheit umfasst außerdem eine mit dem Schallwandler gekoppelte Verstärkereinheit zur Schallwiedergabe und/oder zur Schallaufnahme.

Die Schallerzeugungseinheit kann beispielsweise in Kopfhörern, in Headsets, in In-Ear-Kopfhörern und/oder in Mobiltelefonen angeordnet sein.

Dabei ist die Verstärkereinheit nach einem oder mehreren Merkmalen der vorangegangenen und/oder nachfolgenden Beschreibung ausgebildet.

In einer vorteilhaften Weiterbildung der Schallerzeugungseinheit ist der Schallwandler als ein Simultan-Schallwandler ausgebildet, der als Lautsprecher arbeitend ein Audiosignal abgeben und zeitgleich als Mikrofon arbeitend ein Schallsignal aufnehmen kann. Dabei kann zeitgleich auch bedeuten, dass für einen Hörer der Eindruck entsteht, dass der Simultan-Schallwandler als Mikrofon Schall und insbesondere Umgebungsgeräusche aufnimmt und gleichzeitig als Lautsprecher Musik und insbesondere Antischall abgibt.

Ganz besonders ist es von Vorteil, wenn der Schallwandler ein piezoelektrischer MEMS-Schallwandler ist. Der piezoelektrische MEMS-Schallwandler kann besonders platzsparend ausgebildet werden und weist eine geringe Leistungsaufnahme auf, so dass die Schallerzeugungseinheit energiesparend betrieben werden kann. Außerdem kann der piezoelektrische MEMS-Schallwandler besonders einfach mit dem Audiosignal angesteuert werden.

Ebenso ist es von Vorteil, wenn die Verstärkereinheit und der Schallwandler auf einem einzigen Chip angeordnet sind. Dadurch kann die Schallerzeugungseinheit als ein einziges Bauteil, beispielsweise auf einem ASIC, hergestellt werden. Darüber hinaus, können beispielsweise in einem ASIC die Verbindungswege zwischen den Bauteilen, beispielsweise zwischen dem Prozessor und dem zumindest einen Audioverstärker, kurz gehalten werden, so dass auch die Verarbeitungsgeschwindigkeit der Audiodaten verringert ist. Wenn die Schallerzeugungseinheit auf einem einzigen Chip angeordnet ist, können die Datenverbindungen zwischen den Bauteilen durch einfache Leiterbahnen mit direkt auf dem Chip ausgebildet sein.

Des Weiteren weist der Schallwandler zumindest eine mit einer Membran des Schallwandlers gekoppelte Schallwandlereinheit auf, die die Membran des Schallwandlers zur Schallerzeugung auslenken und zur Schallerfassung eine Auslenkung der Membran erfassen kann. Die Schallwandlereinheit kann ein Schallwandlerelement umfassen, welches beispielsweise piezoelektrische Eigenschaften aufweist. Dadurch kann durch Anlegen eines elektrischen Signals, beispielsweise des Audiosignals, das Schallwandlerelement ausgelenkt werden. Zusätzlich kann bei einer Auslenkung des Schallwandlerelements ein elektrisches Signal, beispielsweise das Schallsignal, erzeugt werden. Das Schallwandlerelement kann ferner mittels eines Koppelelements mit der Membran gekoppelt sein, so dass die Auslenkungen zwischen dem Schallwandlerelement und der Membran übertragen werden können. Werden die Auslenkungen somit von der Schallwandlereinheit auf die Membran übertragen, werden Schallwellen erzeugt. Werden die Auslenkungen von der Membran auf die Schallwandlereinheit übertragen, werden die Schallwellen erfasst.

Außerdem ist es vorteilhaft, wenn die zumindest eine Schallwandlereinheit zumindest zwei Schallwandlerschichten aufweist, wobei mittels einer Schallwandlerschicht die Membran auslenkbar und mittels der anderen Schallwandlerschicht die Auslenkung der Membran erfassbar ist. Dabei kann die eine Schallwandlerschicht als Lautsprecher und die andere Schallwandlerschicht als Mikrofon betrieben werden. Dadurch kann mit einer Schallwandlereinheit gleichzeitig bzw. simultan der Schallwandler als Lautsprecher und als Mikrofon betrieben werden. Des Weiteren können die Schallwandlerschichten mit dem zumindest einen Audioverstärker verbunden sein. Zusätzlich oder alternativ können die Schallwandlerschichten auch mit dem Prozessor der Verstärkereinheit verbunden sein. Wird beispielsweise die erste Schallwandlerschicht als Lautsprecher betrieben, kann diese mit dem Lautsprecherverstärker verbunden sein. Zusätzlich oder alternativ kann dementsprechend die zweite Schallwandlerschicht als Mikrofon betrieben werden und diese mit dem Mikrofonverstärker verbunden sein.

Vorteilhafterweise sind die zumindest zwei Schallwandlerschichten in Richtung der Hubachse übereinander angeordnet. Dadurch lenken sich die beiden Schallwandlerschichten gleichmäßig aus.

Des Weiteren ist es von Vorteil, wenn die zumindest eine Schallwandlereinheit mit dem Prozessor der Verstärkereinheit verbunden ist, so dass dieser mittels der zumindest einen Schallwandlereinheit die Membran zur Schallerzeugung auslenken und zur Schallerfassung die Auslenkung erfassen kann. Der Prozessor kann dadurch beispielsweise die Schallwandlereinheit zwischen dem Betrieb als Lautsprecher und dem Betrieb als Mikrofon umschalten. Zusätzlich oder alternativ kann auch zumindest eine der beiden Schallwandlerschichten mit dem Prozessor der Verstärkereinheit verbunden sein, so dass dieser mittels zumindest einer der beiden Schallwandlerschichten die Membran zur Schallerzeugung auslenken und zur Schallerfassung die Auslenkung erfassen kann.

Ferner ist es von Vorteil, wenn die zumindest zwei Schallwandlereinheiten des Schallwandlers mittels eines Verbindungselements miteinander gekoppelt sind. Das Verbindungselement kann dazu vorteilhafterweise elastisch ausgebildet sein. Dadurch können beispielsweise die Auslenkungen der einen Schallwandlereinheit, die als Lautsprecher betrieben wird, auf die andere Schallwandlereinheit, die als Mikrofon betrieben wird, übertragen werden.

Vorteilhaft ist es auch, wenn der Schallwandler ein Begrenzungselement aufweist, durch das die Membran des Schallwandlers in zumindest einer Richtung einer Hubachse des Schallwandlers in einer Schwingung begrenzt ist. Das Begrenzungselement ist dabei gegenüber der Membran feststehend. Das Begrenzungselement kann beispielsweise einteilig mit einem Trägerelement des Schallwandlers ausgebildet sein. Das Begrenzungselement kann beispielsweise derart angeordnet sein, dass die Membran bei einer Schwingung in eine Richtung zum Begrenzungselement hin an diesem anstößt. Dadurch ist die Schwingung in zumindest eine Richtung entlang der Hubachse begrenzt. Zusätzlich kann die Membran auch mit dem Begrenzungselement verbunden sein, so dass die Schwingung der Membran in beide Richtungen entlang der Hubachse begrenzt ist. Die Membran kann dazu beispielsweise auf dem Begrenzungselement festgeklebt sein. Das Begrenzungselement kann aber auch eine Nut aufweisen, in die die Membran eingeschoben ist, so dass die Schwingung der Membran in beide Richtungen entlang der Hubachse begrenzt ist. Die Schwingung der Membran ist dabei natürlich lediglich im Bereich des Begrenzungselements begrenzt. Benachbart zum Begrenzungselement kann die Membran weiterhin schwingen. Jedoch teilt das Begrenzungselement die Membran in zwei Membranbereiche.

Von Vorteil ist es, wenn die Membran einen ersten Membranbereich und einen zweiten Membranbereich aufweist, wobei eine der Schallwandlereinheiten die Membran im ersten Membranbereich zur Schallerzeugung auslenken und die andere Schallwandlereinheit im zweiten Membranbereich zur Schallerfassung die Auslenkung der Membran erfassen kann. Die beiden Membranbereiche können dabei beispielsweise durch das Begrenzungselement getrennt sein. Dadurch kann der Schallwandler gleichzeitig bzw. simultan als Lautsprecher und als Mikrofon betrieben werden. Ferner kann so der Schallwandler mit einer einzigen Membran betrieben werden.

Ferner kann das Begrenzungselement zwischen den zumindest zwei Schallwandlereinheiten angeordnet ist. Dadurch kann jeweils eine Schallwandlereinheit in jeweils einem Membranbereich angeordnet sein, so dass beispielswiese die Membran im ersten Membranbereich als Lautsprecher und im zweiten Membranbereich als Mikrofon betrieben werden.

Weitere Vorteile der Erfindung sind in den nachfolgenden Ausführungsbeispielen beschrieben. Es zeigen:
- **Figur 1**: ein Blockschaltbild einer Verstärkereinheit mit zwei Audioverstärkern, einem Prozessor und zwei Signalverarbeitungseinheiten,
- **Figur 2**: ein Blockschaltbild eines alternativen Ausführungsbeispiels einer Verstärkereinheit mit zwei Audioverstärkern, einem Prozessor und zwei Signalverarbeitungseinheiten,
- **Figur 3**: ein Blockschaltbild eines alternativen Ausführungsbeispiels einer Verstärkereinheit mit einem hybriden Audioverstärker, einem Prozessor und zwei Signalverarbeitungseinheiten,
- **Figur 4**: eine schematische Schnittansicht eines Schallwandlers mit einem Trägerelement und einer Membran,
- **Figur 5**: eine schematische Schnittansicht eines weiteren Ausführungsbeispiels eines Schallwandlers,
- **Figur 6**: eine schematische Schnittansicht eines weiteren Ausführungsbeispiels eines Schallwandlers, und
- **Figur 7**: eine schematische Schnittansicht eines weiteren Ausführungsbeispiels eines Schallwandlers.

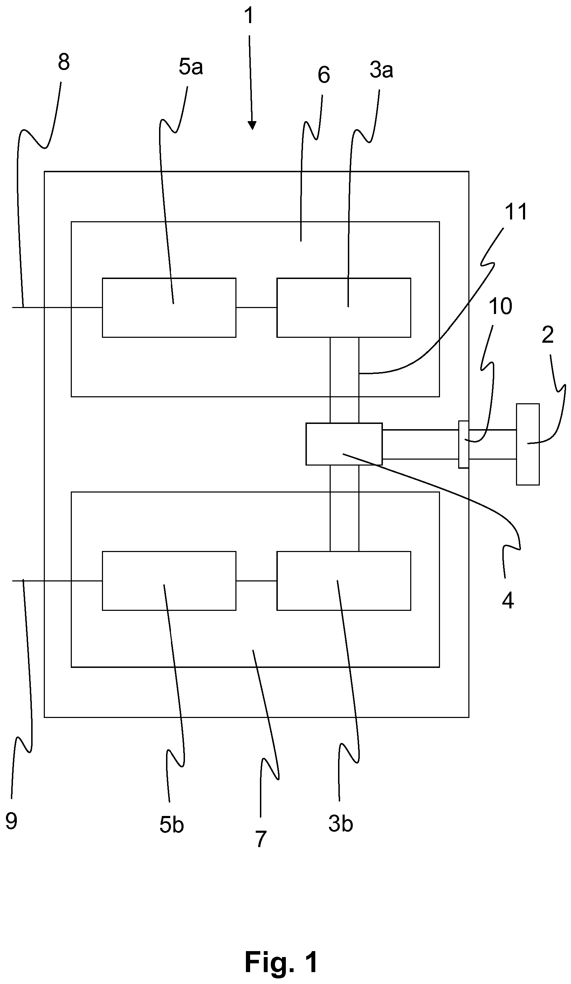

Figur 1 zeigt ein Blockschaltbild einer Verstärkereinheit 1 zum Betreiben eines Schallwandlers 2 mit zwei Audioverstärkern 3a, 3b, einem Prozessor 4 und zwei Signalverarbeitungseinheiten 5a, 5b. Der Audioverstärker 3a ist in diesem Ausführungsbeispiel als Lautsprecherverstärker ausgebildet, der ein Audiosignal für den Schallwandler 2 verstärkt, so dass der Schallwandler 2 als Lautsprecher betrieben werden kann. Der Audioverstärker 3b ist in diesem Ausführungsbeispiel als Mikrofonverstärker ausgebildet, der ein von dem Schallwandler 2 kommendes Schallsignal verstärkt, so dass der Schallwandler 2 als Mikrofon betrieben werden kann.

Des Weiteren sind der Audioverstärker 3a und die Signalverarbeitungseinheit 5a in diesem Ausführungsbeispiel zu einer Lautsprechereinheit 6 und der Audioverstärker 3b und die Signalverarbeitungseinheit 5b zu einer Mikrofoneinheit 7 zusammengefasst. Beispielsweise kann die Lautsprechereinheit 6 und/oder die Mikrofoneinheit 7 als ein Bauteil, insbesondere auf einem einzigen Chip, gefertigt sein, die zur Verstärkereinheit 1 zusammengefügt sind.

Die Verstärkereinheit 1 weist zur Einspeisung eines Audiosignals, beispielsweise der Musik und/oder der Sprache, einen Audioeingang 8 auf, der in die Lautsprechereinheit 9 und/oder in die Signalverarbeitungseinheit 5b führt. Alternativ kann der Audioeingang 8 das Audiosignal auch direkt in den Lautsprecherverstärker 3b führen. Der Audioeingang 8 kann beispielsweise ein Musiksignal von einem MP3-Player, einem CD-Player und/oder ein Funksignal, beispielsweise von einem Mobiltelefon, in die Verstärkereinheit 1 einführen.

Zur Ausspeisung des Audiosignals weist die Verstärkereinheit 1 einen Audioausgang 9 auf, der aus der Mikrofoneinheit 7 heraus- und/oder von der Signalverarbeitungseinheit 5a wegführt. Der Audioausgang 9 kann außerdem das Musik- oder Sprachsignal an eine Speichereinheit und/oder an ein Mobiltelefon führen, wo es gespeichert oder an einen Gesprächspartner gesendet wird.

Der Audioeingang 8 und der Audioausgang 9 können ferner eine hier nicht gezeigte Schnittstelle aufweisen, so dass das Audiosignal beispielsweise kabelgebunden in die Verstärkereinheit 1 eingeführt und/oder ausgeführt werden kann.

Um den Schallwandler 2 an die Verstärkereinheit 1 anschließen zu können, weist diese eine Schnittstelle 10 auf. Die Schnittstelle 10 und/oder die Schnittstellen des Audioeingangs 8 und/oder des Audioausgangs 9 kann kabelgebunden und/oder bidirektional und/oder beispielsweise als ein Klinkenstecker, ein Cinchstecker, ein XLR-Stecker, ein Speakon-Steckverbindung und/oder eine USB-Verbindung ausgebildet sein, so dass beispielsweise der Schallwandler 2 lösbar mit der Verstärkereinheit 1 verbunden werden kann. Die Schnittstellen können zusätzlich oder alternativ auch optisch ausgebildet sein.

Zusätzlich oder alternativ kann der Schallwandler 2 beispielsweise auch mittels einer Lötverbindung fest an die Schnittstelle 10 angekoppelt werden.

In diesem Ausführungsbeispiel ist zwischen dem Audioverstärker 3a und dem Audioverstärker 3b der Prozessor 4 angeordnet, welcher mittels Datenverbindungen 11 (der Einfachheit halber ist nur eine Datenverbindung mit einem Bezugszeichen versehen) jeweils mit den beiden Audioverstärkern 3a, 3b verbunden ist. Des Weiteren führt eine Datenverbindung 11 von dem Prozessor 4 zur Schnittstelle 10.

Die Datenverbindung 11 kann ebenfalls kabelgebunden und/oder bidirektional ausgebildet sein. Die Datenverbindung 11 kann dazu ausgebildet sein, ein elektrisches und/oder optisches Signal zu übertragen. Ferner kann die Datenverbindung 11 auch als eine Leiterbahn auf einer Leiterplatine ausgebildet sein.

Die Verstärkereinheit 1 kann außerdem beispielsweise in einem Kopfhörer, einem Headset, einem In-Ear-Kopfhörer, einem Helm mit Lautsprecher(n) oder in einem Mobiltelefon angeordnet sein, wobei mit Hilfe der Verstärkereinheit 1 durch den Schallwandler 2 eine Musik, ein Ton und/oder Sprache abgespielt und/oder aufgenommen werden kann. Wenn eine Musik aufgenommen werden soll, kann der Schallwandler 2 als Mikrofon genutzt werden. Wenn eine Musik abgespielt werden soll, kann der Schallwandler 2 als Lautsprecher genutzt werden.

Mittels der erfindungsgemäßen Verstärkereinheit 1 kann auch ein "active noise reduction"-Verfahren (ANR-Verfahren) durchgeführt werden. Dazu ist die Verstärkereinheit 1 derart ausgebildet, dass sie den Schallwandler 2 zur Schallaufnahme als Mikrofon und simultan zur Schallwiedergabe als Lautsprecher betreiben kann.

Dabei kann simultan auch bedeuten, dass lediglich der Hörer der Musik, des Tons oder der Sprache den Eindruck erhält, das Auslöschen der Umgebungsgeräusche durch den Antischall sei zeitgleich. Beispielsweise aufgrund einer endlichen zeitlichen Auflösung des menschlichen Hörens, kann es ausreichend sein, wenn das Auslöschen der Umgebungsgeräusche durch den Antischall innerhalb der kürzesten zeitlichen Auflösung des menschlichen Hörens erfolgt.

Mittels des Prozessors 4, der auch als digitaler Signalprozessor ausgebildet sein kann, kann der Schallwandler 2 während der Schallerzeugung zeitgleich als Mikrofon genutzt werden.

Beispielsweise kann der Prozessor 4 eine Recheneinheit umfassen, in der ein Computerprogramm ausgeführt wird, das den vom Schallwandler 2 aufgenommenen Schall bearbeitet. Der Prozessor 4 kann beispielsweise die Umgebungsgeräusche aus dem aufgenommenen Schall herausfiltern. Der Prozessor 4 kann aus den Umgebungsgeräuschen auch den Antischall bilden, der zusammen mit der Musik durch den Schallwandler 2 abgespielt wird und die Umgebungsgeräusche auslöscht. Das Abspielen der Musik und des Antischalls kann dabei zeitgleich zur Aufnahme der Umgebungsgeräusche erfolgen, so dass die Umgebungsgeräusche im Wesentlichen unmittelbar durch den entsprechenden Antischall ausgelöscht werden.

Als Mikrofon nimmt der Schallwandler 2 somit beispielsweise Musik und Umgebungsgeräusche auf. Die Verstärkereinheit 1 isoliert die Umgebungsgeräusche und erzeugt daraus einen entsprechenden Antischall. Der Antischall wird zusammen mit der abzuspielenden Musik durch den Schallwandler 2, der nun als Lautsprechen dient, wiedergegeben. Dabei kann der Antischall mit der Musik durch den Schallwandler 2 zeitgleich zur Aufnahme der Umgebungsgeräusche abgespielt werden. Der Antischallteil des so erzeugten Schalls interferiert destruktiv mit den Umgebungsgeräuschen und löscht diese dadurch aus. Übrig bleibt lediglich die Musik, die von einem Hörer wahrgenommen wird.

Durch die Aufnahme des Schalls, der insbesondere die Umgebungsgeräusche enthält, und der simultane Erzeugung des Schalls durch den einzigen Schallwandler 2 kann das "active noise reduction"-Verfahren mit einer hohen Qualität durchgeführt werden. Das Auslöschen der Umgebungsgeräusche durch den entsprechenden Antischall erfolgt durch den einen Schallwandler 2 an dem Ort, an dem auch die Umgebungsgeräusche aufgenommen werden. Dadurch müssen bei der Berechnung des Antischalls keine Laufzeiten zwischen dem Ort der Aufnahme der Umgebungsgeräusche und der Wiedergabe des Antischalls mitberechnet werden, so dass der Antischall schneller berechnet werden kann.

Es kann aber auch die Verstärkereinheit 1 in einem Fertigungsschritt auf einem Chip hergestellt werden. Beispielsweise können die Audioverstärker 3a, 3b, der Prozessor 4, die Signalverarbeitungseinheiten 5a, 5b und/oder die Datenverbindungen 11 auf dem Chip angeordnet sein. Zusätzlich oder alternativ können auch die Schnittstelle 10 und/oder die Schnittstellen des Audioeingangs 8 und/oder des Audioausgangs 9 auf dem Chip angeordnet sein.

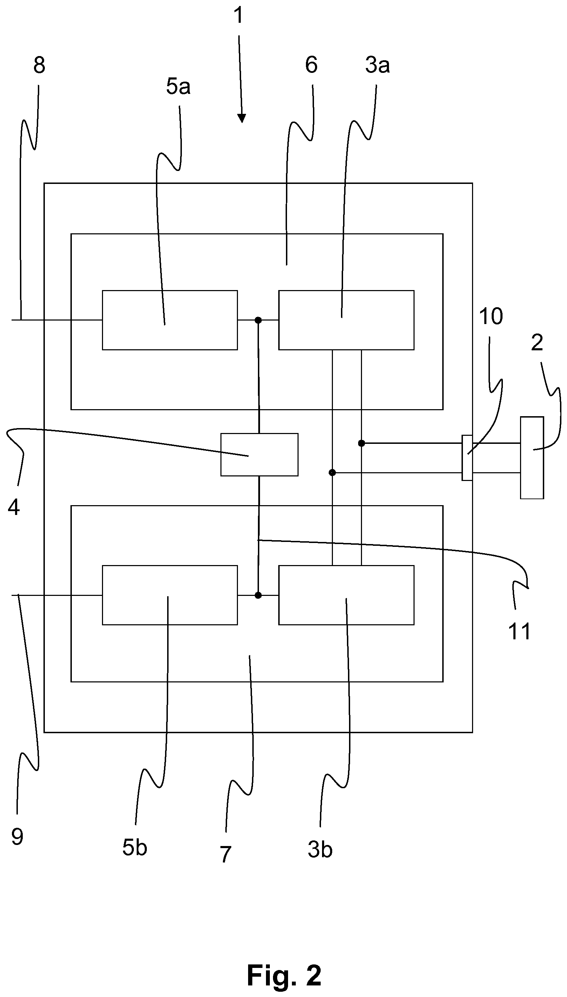

Figur 2 zeigt ein alternatives Ausführungsbeispiel der Verstärkereinheit 1 in einem Blockschaltbild. Die zur Figur 1 gleichen Merkmale und Funktionen werden ab hier der Einfachheit halber nicht nochmals beschrieben. Der Prozessor 4 ist in diesem Ausführungsbeispiel zwischen der Lautsprechereinheit 6 und der Mikrofoneinheit 7 angeordnet. Der Prozessor 4 weist jeweils eine Datenverbindung 11 zur Lautsprechereinheit 6 und zur Mikrofoneinheit 7 auf. Der Prozessor 4 ist dabei mittels der Datenverbindung 11 zwischen der Signalverarbeitungseinheit 5a und dem Audioverstärker 3a angekoppelt. Außerdem ist der Prozessor 4 mittels der Datenverbindung 11 zwischen der Signalverarbeitungseinheit 5b und dem Audioverstärker 3b angekoppelt.

Der Prozessor 4 kann in diesem Ausführungsbeispiel den vom Audioverstärker 3b bearbeiteten Schall, der insbesondere die Umgebungsgeräusche und die Musik enthält, weiterbearbeiten. Insbesondere kann der Prozessor 4 aus den Umgebungsgeräuschen den Antischall erzeugen. Der Prozessor 4 kann daraufhin den Antischall in die Lautsprechereinheit 6 leiten, in der der Antischall durch den Audioverstärker 3a zur Schallwidergabe an den Schallwandler 2 geleitet wird.

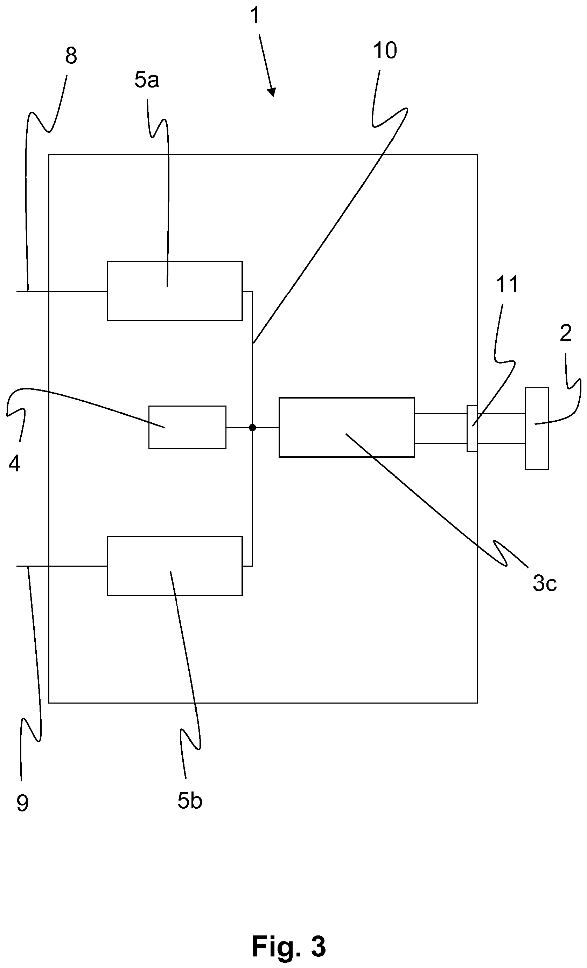

Figur 3 zeigt ein weiteres alternatives Ausführungsbeispiel der Verstärkereinheit 1 mit einem Schallwandler 2, einem hybriden Audioverstärker 3c, einem Prozessor 4 und zwei Signalverarbeitungseinheiten 5a, 5b.

In diesem Ausführungsbeispiel weist die Verstärkereinheit 1 einen einzigen hybriden Audioverstärker 3c auf, der zur Schallwiedergabe das Audiosignal verstärken kann, um es dem Schallwandler 2 zuzuführen und der, insbesondere simultan, zur Schallaufnahme das Schallsignal vom Schallwandler 2 verarbeiten kann, um es beispielsweise abzuspeichern. Der hybride Audioverstärker 3c kann dabei beispielsweise auch die Umgebungsgeräusche aus dem aufgenommenen Schallsignal herausfiltern und daraus den Antischall erzeugen. Der hybride Audioverstärker 3c kann auch den Antischall wieder verstärken und zusammen mit der Musik zur Schallwiedergabe an den Schallwandler 2 leiten. Zusätzlich oder alternativ kann auch der Prozessor 4 die Umgebungsgeräusche aus dem aufgenommenen Schallsignal herausfiltern und den Antischall erzeugen.

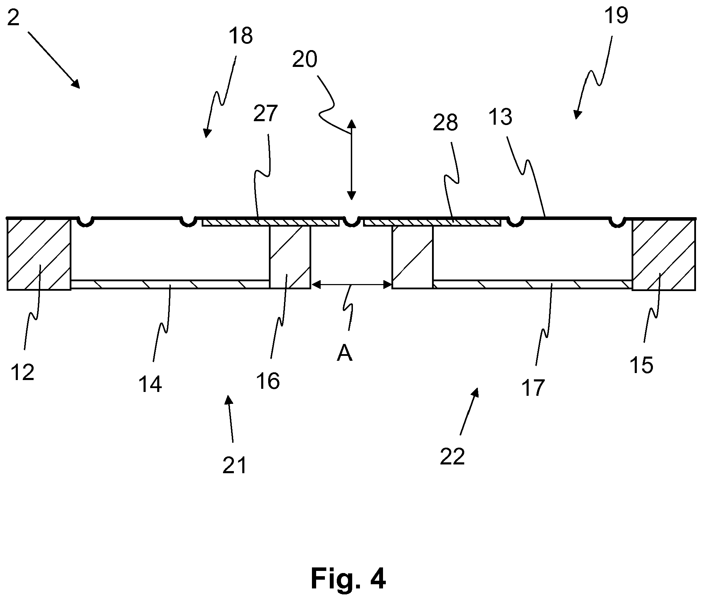

Figur 4 zeigt eine schematische Schnittansicht eines Schallwandlers 2 mit einem Trägerelement 12 und einer Membran 13. Der Schallwandler 2 weist ein Trägerelement 12 auf, an dem eine Membran 13 angeordnet ist. Mit Hilfe der Membran 13 kann eine darüber angeordnete Luft in Schwingung versetzt werden, so dass Schallwellen erzeugt werden. Der Schallwandler 2 wird dadurch als Lautsprecher betrieben. Zusätzlich kann auch eine infolge der Schallwellen schwingende Luft über der Membran 13 diese in Schwingung versetzen. Der Schallwandler 2 wird dadurch als Mikrofon betrieben. Die Membran 13 kann dabei entlang einer Hubachse 20 ausgelenkt werden.

Gemäß dem vorliegenden Ausführungsbeispiel weist der Schallwandler 2 eine erste Schallwandlereinheit 21 und eine zweite Schallwandlereinheit 22 auf.

Die erste Schallwandlereinheit 21 kann ferner ein erstes Schallwandlerelement 14 aufweisen, das vorliegend mittels eines ersten Koppelelements 16 mit der Membran 13 verbunden ist. Die zweite Schallwandlereinheit 22 kann ein zweites Schallwandlerelement 15 aufweisen, das vorliegend mittels eines zweiten Koppelelements 17 mit der Membran 13 verbunden ist. Die beiden Koppelelemente 16, 17 können dabei fest mit der Membran 13 verbunden sein.

Zwischen den Koppelelementen 16, 17 und der Membran 13 ist gemäß dem vorliegenden Ausführungsbeispiel jeweils eine Koppelplatte 27, 28 angeordnet. Durch die jeweilige Koppelplatte 27, 28 kann eine flächige Übertragung der Auslenkung zwischen der Membran 13 und der jeweiligen Schallwandlereinheit 21, 22 ermöglicht werden.

Das erste und/oder das zweite Schallwandlerelement 14, 15 kann beispielsweise ein Piezoelement umfassen, so dass ein elektrisches Signal in eine Auslenkung des Schallwandlerelements 14, 15 und/oder eine Auslenkung des Schallwandlerelements 14, 15 in ein elektrisches Signal umgewandelt werden kann. Da das erste und/oder das zweite Schallwandlerelement 14, 15 mittels des entsprechenden Koppelelements 16, 17 mit der Membran 13 verbunden ist, können die Auslenkungen der Schallwandlerelemente 14, 15 auf die Membran 13 und/oder die Schwingungen der Membran 13 auf die Schallwandlerelemente 14, 15 übertragen werden.

Die erste Schallwandlereinheit 21 wird als Lautsprecher betrieben. Mit Hilfe der ersten Schallwandlereinheit 21 werden somit Schallwellen erzeugt. Die zweite Schallwandlereinheit 22 wird als Mikrofon betrieben. Mittels der zweiten Schallwandlereinheit 22 werden somit die Schallwellen aufgenommen. Dabei kann die erste Schallwandlereinheit 21 simultan bzw. gleichzeitig zur zweiten Schallwandlereinheit 22 betrieben werden, so dass simultan bzw. gleichzeitig mit dem Schallwandler 2 Schallwellen erzeugt und erfasst werden können. Da beiden Schallwandlereinheiten 21, 22 mit einer Membran 13 gekoppelt sind, können mit Hilfe des Schallwandlers 2 die Schallwellen erzeugt und erfasst werden.

Beispielsweise wird die erste Schallwandlereinheit 21 als Lautsprecher betrieben, so dass anhand eines Audiosignals, welches wiederum Musik, Töne und Sprache sowie den Antischall umfassen kann, Schallwellen erzeugt werden.

Die zweite Schallwandlereinheit 22 kann beispielsweise als Mikrofon betrieben werden, so dass anhand der Schallwellen ein Schallsignal erfasst wird. Das erfasste Schallsignal kann dabei zwei Schallsignalanteile aufweisen. Ein erster Schallsignalanteil kann beispielsweise die Umgebungsgeräusche aufweisen. Zusätzlich kann ein zweiter Schallsignalanteil die Sprache, die Töne und Musik und/oder den Antischall aufweisen, die/der gleichzeitig von der ersten Schallwandlereinheit 21 erzeugt werden. Das erfasste Schallsignal ist somit aus dem ersten und dem zweiten Schallsignalanteil zusammengesetzt. Da jedoch der zweite Schallsignalanteil bekannt ist, da dieser dem Audiosignal entspricht, welches an der ersten Schallwandlereinheit 22 erzeugt wird, kann dieser zweite Schallsignalanteil vom Schallsignal herausgefiltert werden. Beispielsweise kann der zweite Schallsignalanteil vom Schallsignal abgezogen werden. Es kann ein Differenzsignal ermittelt werden. Dadurch kann der erste Schallsignalanteil, welcher die Umgebungsgeräusche umfasst, ermittelt werden.

Die erste Schallwandlereinheit 21 ist gemäß dem vorliegenden Ausführungsbeispiel der Figur 4 in einem ersten Schallwandlerbereich 18 angeordnet. Zusätzlich oder alternativ ist die zweite Schallwandlereinheit 22 gemäß dem vorliegenden Ausführungsbeispiel in einem zweiten Schallwandlerbereich 19 angeordnet. Die beiden Schallwandlerbereiche 18, 19 können einen Abstand A zueinander aufweisen. Zusätzlich oder alternativ können auch die beiden Schallwandlereinheiten 21, 22 zueinander den Abstand A aufweisen. Durch den Abstand A sind auch die Koppelelemente 16, 17 zueinander beabstandet, welche die Auslenkung zwischen der Membran 13 und den entsprechenden Schallwandlerelementen 14, 15 übertragen. Dadurch beeinflussen sich die beiden Schallwandlereinheiten 21, 22 zur Erzeugung und/oder Erfassung der Schallwellen nur wenig.

Beispielsweise wird die ersten Schallwandlereinheit 21 als Lautsprecher betrieben, so dass mit diesem Schallwellen erzeugt werden. Das Koppelelement 16 überträgt die Auslenkungen des ersten Schallwandlerelements 14 im ersten Schallwandlerbereich 18 auf die Membran, welche entsprechende Schwingungen ausbildet. Die zweite Schallwandlereinheit 22 kann zeitgleich bzw. simultan zur ersten Schallwandlereinheit 22 als Mikrofon betrieben werden. Durch Schallwellen wird die Membran 13 im zweiten Schallwandlerbereich 19 in Schwingung versetzt, welche durch das Koppelelement 17 auf das zweite Schallwandlerelement 15 übertragen werden. Mit Hilfe eines einzigen Schallwandlers 2 können somit gleichzeitig bzw. simultan Schallwellen erzeugt und erfasst werden.

Alternativ können auch beide Schallwandlereinheiten 21, 22 als Lautsprecher und/oder als Mikrofon betrieben werden. Beispielsweise können die beiden Schallwandlereinheiten 21, 22 in einem Lautsprecherintervall als Lautsprecher und in einem zeitlich darauf folgenden Mikrofonintervall als Mikrofon betrieben werden.

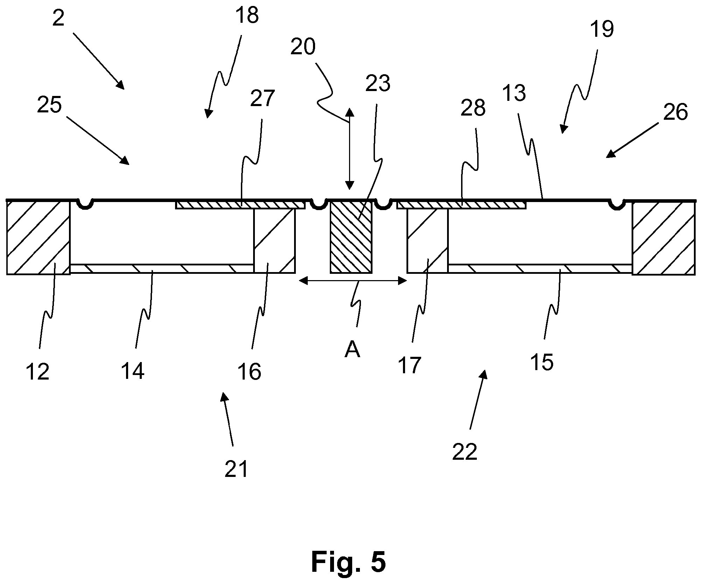

Figur 5 zeigt eine schematische Schnittansicht eines weiteren Ausführungsbeispiels eines Schallwandlers 2. Der Einfachheit halber werden die zu den vorangegangenen Figuren gleichen Merkmale nicht nochmals erklärt.

Beispielsweise kann die Membran 13 im ersten Membranbereich 25 mittels der ersten Schallwandlereinheit 21 in Schwingung versetzt werden, so dass Schallwellen erzeugt werden. Die Membran 13 wird somit im ersten Membranbereich 25 für die Lautsprecherfunktion des Schallwandlers 2 verwendet. Im zweiten Membranbereich 26 können Schallwellen die Membran 13 in Schwingung versetzen, die von der zweiten Schallwandlereinheit 22 erfasst werden können. Die Membran 13 wird somit im zweiten Membranbereich 26 für die Mikrofonfunktion des Schallwandlers 2 verwendet.

Die Membran 13 kann des Weiteren einen ersten Membranbereich 25 und einen zweiten Membranbereich 26 aufweisen. Die beiden Membranbereiche 25, 26 sind gemäß dem vorliegenden Ausführungsbeispiel benachbart zueinander auf der Membran 13 angeordnet. Zwischen den beiden Membranbereichen 25, 26 ist in diesem Ausführungsbeispiel der Figur 5 ein Begrenzungselement 23 angeordnet.

Mittels des Begrenzungselements 23 kann eine Auslenkung der Membran 13 im Bereich des Begrenzungselements 23 entlang der Hubachse 20 eingeschränkt werden. Beispielsweise kann die Membran 13, insbesondere lose, auf dem Begrenzungselement 23 aufliegen, so dass eine Auslenkung entlang der Hubachse 20 in Richtung des Begrenzungselements 23 verhindert ist. Zusätzlich oder alternativ kann die Membran 13 auch mit dem Begrenzungselement 23 verbunden sein, so dass eine Auslenkung entlang der Hubachse 20 in beide Richtungen begrenzt ist. Die Membran 13 kann beispielsweise auf dem Begrenzungselement 23 aufgeklebt sein. Das Begrenzungselement 23 kann beispielsweise einteilig mit dem Trägerelement 12 ausgebildet sein.

Der erste Schallwandlerbereich 18 kann dabei im ersten Membranbereich 25 und der zweite Schallwandlerbereich 19 kann im zweiten Membranbereich 26 angeordnet sein.

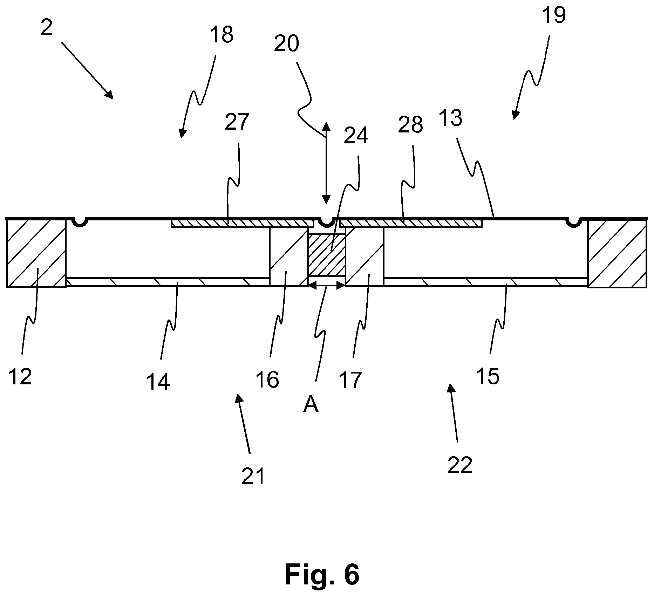

Figur 6 zeigt eine schematische Schnittansicht eines weiteren Ausführungsbeispiels eines Schallwandlers 2.

Gemäß dem vorliegenden Ausführungsbeispiel sind die beiden Schallwandlereinheiten 21, 22 mittels eines Verbindungselements 23 miteinander verbunden. Das Verbindungselement 23 koppelt die beiden Schallwandlereinheiten 21, 22, so dass die Auslenkungen der Schallwandlereinheiten 21, 22 auf die jeweilig andere Schallwandlereinheit 21, 22 übertragen wird. Gemäß dem vorliegenden Ausführungsbeispiel ist das Verbindungselement 23 zwischen den beiden Koppelelementen 16, 17 der beiden Schallwandlereinheiten 21, 22 angeordnet.

Das Verbindungselement 24 kann ferner elastisch ausgebildet sein, so dass ein durch die Auslenkung der Schallwandlerelemente 21, 22 bedingte Änderung des Abstands A ausgeglichen werden kann. Das Verbindungselement 24 kann beispielsweise ein Federelement aufweisen.

Des Weiteren können die erste und/oder die zweite Schallwandlereinheit 21, 22 mit dem zumindest einen Audioverstärker 3 verbunden sein. Wird beispielsweise die erste Schallwandlereinheit 21 zum Erzeugen der Schallwellen als Lautsprecher betrieben die erste Schallwandlereinheit 21, kann die erste Schallwandlereinheit 21 mit dem Audioverstärker 3 verbunden sein, der als Lautsprecherverstärker betrieben wird. Wenn die erste Schallwandlereinheit 21 als Lautsprecher betrieben wird, kann diese beispielsweise mit dem Audioverstärker 3a der Figur 1 und 2 verbunden sein. Wird beispielsweise die zweite Schallwandlereinheit 22 beispielsweise zum Erfassen der Schallwellen als Mikrofon betrieben, kann die zweite Schallwandlereinheit 22 ebenfalls mit einem Audioverstärker 3 verbunden sein. Wir die zweite Schallwandlereinheit 22 beispielsweise als Mikrofon betrieben, kann diese beispielsweise mit dem Audioverstärker 3b der Figur 1 und 2 verbunden sein.

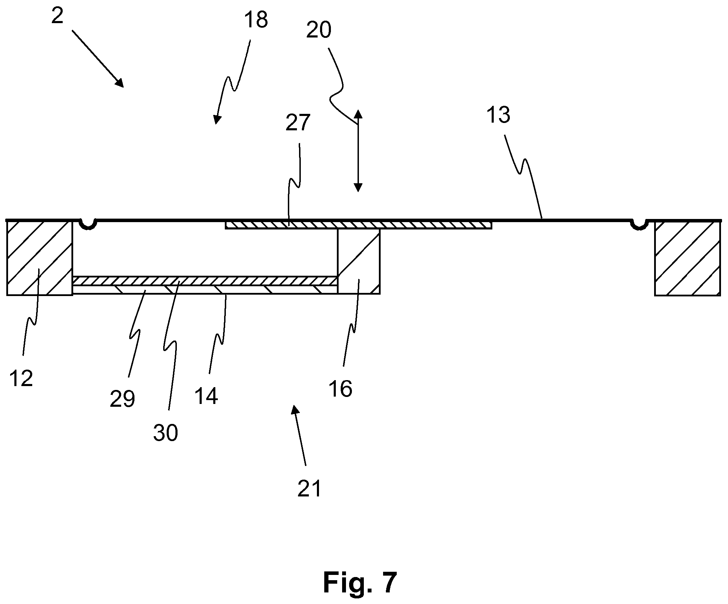

Figur 7 zeigt eine schematische Schnittansicht eines weiteren Ausführungsbeispiels eines Schallwandlers 2. Die Ausführung mit lediglich einer Schallwandlereinheit 21, 22 gehört nicht zur Erfindung. Das Schallwandlerelement 14 kann gemäß dem vorliegenden Ausführungsbeispiel eine erste Schallwandlerschicht 29 und eine zweite Schallwandlerschicht 30 aufweisen. Beide Schallwandlerschichten 29, 30 können dabei das Schallwandlerelement 14 bilden. Die beiden Schallwandlerschichten 29, 30 können in Richtung der Hubachse 20 übereinander angeordnet sein. Die beiden Schallwandlerschichten 29, 30 können dabei jeweils als Piezoelement ausgebildet sein. Das erste Schallwandlerelement 14 des vorliegenden Ausführungsbeispiels kann durch zwei übereinander angeordnete Piezoelemente ausgebildet sein.

Von Vorteil dabei ist es, wenn eine der beiden Schallwandlerschichten 29, 30 zum Erzeugen der Schallwellen als Lautsprecher und die andere Schallwandlerschicht 29, 30 zum Erfassen der Schallwellen als Mikrofon betrieben wird. Mit einer Schallwandlerschicht 29, 30 können somit die Schallwellen erzeugt und mit der anderen Schallwandlerschicht 29, 30 können die Schallwellen erfasst werden.

Die Schallwellen können somit von beispielsweise der ersten Schallwandlerschicht 29 erzeugt und gleichzeitig bzw. simultan dazu mit der zweiten Schallwandlereinheit 30 erfasst werden.

Die beiden Schallwandlerschichten 29, 30 können ferner mit den jeweiligen Audioverstärkern 3a, 3b verbunden sein. Die Schallwandlerschicht 29, 30, die als Lautsprecher betrieben wird, kann dabei mit dem als Lautsprecherverstärker betriebenen Audioverstärker 3a, 3b und die Schallwandlerschicht 29, 30, die als Mikrofon betrieben wird, kann mit dem als Mikrofonverstärker betriebenen Audioverstärker 3a, 3b verbunden sein.

Alternativ kann der Schallwandler 2 auch zwei Schallwandlereinheiten 21, 22, ähnlich zu den vorangegangenen Figuren, mit zumindest zwei Schallwandlerschichten 29, 30, aufweisen.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind.

### Bezugszeichenliste

- 1: Verstärkereinheit
- 2: MEMS-Schallwandler
- 3: Audioverstärker
- 4: Prozessor
- 5: Signalverarbeitungseinheit
- 6: Lautsprechereinheit
- 7: Mikrofoneinheit
- 8: Audioeingang
- 9: Audioausgang
- 10: Schnittstelle
- 11: Datenverbindung
- 12: Trägerelement
- 13: Membran
- 14: erstes Schallwandlerelement
- 15: zweites Schallwandlerelement
- 16: erstes Koppelelement
- 17: zweites Koppelelement
- 18: erster Schallwandlerbereich
- 19: zweiter Schallwandlerbereich
- 20: Hubachse
- 21: erste Schallwandlereinheit
- 22: zweite Schallwandlereinheit
- 23: Begrenzungselement
- 24: Verbindungselement
- 25: erster Membranbereich
- 26: zweiter Membranbereich
- 27: erste Koppelplatte
- 28: zweite Koppelplatte
- 29: erste Schallwandlerschicht
- 30: zweite Schallwandlerschicht

- A: Abstand

## Patentansprüche

1. Schallerzeugungseinheit
mit einem MEMS-Schallwandler (2), der als Mikrofon und als Lautsprecher betreibbar ist, und
einer mit dem MEMS-Schallwandler (2) gekoppelten Verstärkereinheit (1) zur Schallwiedergabe und Schallaufnahme,
wobei die Verstärkereinheit (1) zumindest einen Audioverstärker (3a, 3b) zur Schallwiedergabe und Schallaufnahme aufweist,
wobei die Verstärkereinheit (1) derart ausgebildet ist, dass der dafür vorgesehene MEMS-Schallwandler (2) simultan als Lautsprecher und als Mikrofon betreibbar ist, und
wobei die Aufnahme des Schalls und die simultane Erzeugung des Schalls durch einen einzigen MEMS-Schallwandler (2) durchgeführt werden kann,
**dadurch gekennzeichnet,**
**dass** der MEMS-Schallwandler (2) eine erste und eine zweite mit einer Membran (13) des MEMS-Schallwandlers (2) gekoppelte Schallwandlereinheit (21, 22) aufweist, wobei mit Hilfe der ersten Schallwandlereinheit (21) die Schallwellen erzeugt und mit Hilfe der zweiten Schallwandlereinheit (22) die Schallwellen aufgenommen werden können.

2. Schallerzeugungseinheit nach dem vorherigen Anspruch, **dadurch gekennzeichnet, dass** der MEMS-Schallwandler (2) als Simultan-Schallwandler ausgebildet ist, der als Lautsprecher arbeitend ein Audiosignal abgeben und zeitgleich als Mikrofon arbeitend ein Schallsignal aufnehmen kann und/oder dass der MEMS-Schallwandler (2) ein piezoelektrischer MEMS-Schallwandler ist und/oder dass die Verstärkereinheit (1) und der MEMS-Schallwandler (2) auf einem einzigen Chip angeordnet sind.

3. Schallerzeugungseinheit nach einem oder mehreren der vorherigen Ansprüche 1 - 2, **dadurch gekennzeichnet, dass** die beiden Schallwandlereinheiten (21, 22) zumindest zwei Schallwandlerschichten (29, 30) aufweisen, wobei mittels einer Schallwandlerschicht (29, 30) die Membran (13) auslenkbar und mittels der anderen Schallwandlerschicht die Auslenkung der Membran (13) erfassbar ist.

4. Schallerzeugungseinheit nach einem oder mehreren der vorherigen Ansprüche 1 - 3, **dadurch gekennzeichnet, dass** die beiden Schallwandlereinheiten (21, 22) und/oder zumindest eine der beiden Schallwandlerschichten (29, 30) mit einem Prozessor (4) der Verstärkereinheit (1) verbunden sind, so dass dieser mittels beider Schallwandlereinheiten (21, 22) und/oder zumindest eine der beiden Schallwandlerschichten (29, 30) die Membran (13) zur Schallerzeugung auslenken und zur Schallerfassung die Auslenkung erfassen kann.

5. Schallerzeugungseinheit nach einem oder mehreren der vorherigen Ansprüche 1 - 4, **dadurch gekennzeichnet, dass** die zumindest zwei Schallwandlereinheiten (21, 22) des MEMS-Schallwandlers (2) mittels eines, insbesondere elastischen, Verbindungselements (24) miteinander verbunden sind und/oder dass der MEMS-Schallwandler (2) ein Begrenzungselement (23) aufweist, durch das die Membran (13) in zumindest eine Richtung einer Hubachse (20) des Schallwandlers (2) in der Auslenkung begrenzt ist.

6. Schallerzeugungseinheit nach einem oder mehreren der vorherigen Ansprüche 1 - 5, **dadurch gekennzeichnet, dass** die Membran (13), insbesondere durch das Begrenzungselement (23) getrennt, einen ersten Membranbereich (25) und einen zweiten Membranbereich (26) aufweist, wobei eine der Schallwandlereinheiten (21, 22) die Membran (13) im ersten Membranbereich (25) zur Schallerzeugung auslenken und die andere Schallwandlereinheit (21, 22) im zweiten Membranbereich (26) zur Schallerfassung die Auslenkung der Membran (13) erfassen kann.

7. Schallerzeugungseinheit nach zumindest dem Anspruch 4, **dadurch gekennzeichnet, dass** die Verstärkereinheit (1) den Prozessor (4), insbesondere einen digitalen Signalprozessor, aufweist, mittels dem der dafür vorgesehene MEMS-Schallwandler (2) während der Schallerzeugung zeitgleich als Mikrofon genutzt werden kann und/oder dass der Prozessor (4) zur Geräuschunterdrückung derart ausgebildet ist, dass dieser anhand eines ausgesendeten Audiosignals und einem zeitgleich mit demselben MEMS-Schallwandler (2) erfassten Schallsignals Umgebungsgeräusche herausfiltern und/oder unterdrücken kann.

8. Schallerzeugungseinheit nach einem der vorherigen Ansprüche 4 - 7, **dadurch gekennzeichnet, dass** der Prozessor (4) derart ausgebildet ist, dass dieser ein Schallsignal, das vom als Mikrofon arbeitenden MEMS-Schallwandler (2) erfasst wird, in einen die ausgesendeten Nutzgeräusche repräsentierenden ersten Schallsignalanteil und einen die Umgebungsgeräusche repräsentierenden zweiten Schallsignalanteil trennt, und/oder dass der Prozessor (4) derart ausgebildet ist, dass dieser anhand des zweiten Schallsignalanteils ein Antischallsignal erzeugt und dieses mit einem Nutzgeräusche umfassenden Eingangssignal zum Audiosignal zusammenfasst.

9. Schallerzeugungseinheit nach einem oder mehreren der vorherigen Ansprüche 4 - 8, **dadurch gekennzeichnet, dass** der Prozessor (4) derart ausgebildet ist, dass dieser den MEMS-Schallwandler (2) zwischen dem Betrieb als Lautsprecher und dem Betrieb als Mikrofon umschalten kann.

10. Schallerzeugungseinheit nach einem oder mehreren der vorherigen Ansprüche 1 - 9, **dadurch gekennzeichnet, dass** die Verstärkereinheit (1) einen hybriden Audioverstärker (3c) aufweist, mittels dem zur Schallwiedergabe das Audiosignal an den dafür vorgesehenen MEMS-Schallwandler (2) ausgegeben und zur Schallaufnahme das Schallsignal des MEMS-Schallwandlers (2) empfangen werden kann und/oder dass die Verstärkereinheit (1) einen Lautsprecherverstärker (3a) zur Schallwiedergabe des Audiosignals und einen Mikrofonverstärker (3b) zur Schallaufnahme des Schallsignals aufweist.

11. Schallerzeugungseinheit nach einem oder mehreren der vorherigen Ansprüche 1 - 10, **dadurch gekennzeichnet, dass** die Verstärkereinheit (1) zumindest eine Signalverarbeitungseinheit (5a, 5b) aufweist, die mit dem zumindest einen Audioverstärker (3a, 3b) verbunden ist und mittels der das Audiosignal zur Schallwiedergabe vorbereitbar und/oder das Schallsignal zur Schallaufnahme aufbereitbar ist.

12. Schallerzeugungseinheit nach einem oder mehreren der vorherigen Ansprüche 4 - 11, **dadurch gekennzeichnet, dass** der Prozessor (4) eine Datenverbindung (11) zu dem zumindest einen Audioverstärker (3a, 3b) und/oder zu der zumindest einen Signalverarbeitungseinheit (5a, 5b) aufweist, über die dem Prozessor (4) die ausgesendeten Audiosignale und erfassten Schallsignale und die in der Signalverarbeitungseinheit (5a, 5b) zu verarbeitenden Audiodaten übermittelt werden können, und/oder dass die Verstärkereinheit (1) zumindest eine, insbesondere kabelgebundene und/oder bidirektionale, Schnittstelle (10) aufweist, über die vorzugsweise zeitgleich Audiosignale von der Verstärkereinheit (1) an den MEMS-Schallwandler (2) und Schallsignale von diesem an die Verstärkereinheit (1) übermittelt werden können.

## Claims

1. A sound generating unit
having a MEMS sound transducer (2), which is operable as a microphone and as a loudspeaker, and
having an audio amplifier unit (1) coupled to the MEMS transducer (2) for sound reproduction and sound recording,
wherein the audio amplifier unit (1) comprises at least one amplifier (3a, 3b) for sound reproduction and sound recording,
wherein the amplifier unit (1) is designed in such a way that the MEMS sound transducer (2) provided therefor is operable simultaneously as a loudspeaker and as a microphone and
wherein the sound recording and simultaneous sound generation can be performed by a single MEMS sound transducer (2),
**characterized in that**
the MEMS sound transducer (2) comprises a first and second sound transducer unit (21, 22) coupled to a diaphragm (13) of the MEMS sound transducer (2), wherein the sound waves are generated by means of the first sound transducer unit (21) and recorded by means of the second sound transducer unit (22).

2. The sound-generating unit as claimed in the preceding claim, **characterized in that** the MEMS sound transducer (2) is designed as a simultaneous sound transducer, which, operating as a loudspeaker, can output an audio signal and, at the same time, operating as a microphone, can record an acoustic signal and/or the MEMS sound transducer (2) is a piezoelectric MEMS sound transducer and/or the amplifier unit (1) and the MEMS sound transducer (2) are arranged on a single chip.

3. The sound-generating unit as claimed in one or more of the preceding claims 1 to 2, **characterized in that** the two sound transducer unit (21, 22) comprise at least two sound transducer layers (29, 30), wherein the diaphragm (13) is deflectable with the aid of one sound transducer layer (29, 30) and the deflection of the diaphragm (13) is detectable with the aid of the other sound transducer layer.

4. The sound-generating unit as claimed in one or more of the preceding claims 1 to 3, **characterized in that** the both sound transducer unit (21, 22) and/or at least one of the two sound transducer layers (29, 30) are/is connected to a processor (4) of the amplifier unit (1), so that the processor (4) can deflect the diaphragm (13) for sound generation and can detect the deflection for sound detection with the aid of the both sound transducer unit (21, 22) and/or at least one of the two sound transducer layers (29, 30).

5. The sound-generating unit as claimed in one or more of the preceding claims 1 to 4, **characterized in that** the at least two sound transducer units (21, 22) of the MEMS sound transducer (2) are connected to one another with the aid of an, in particular, elastic connecting element (24) and/or the MEMS sound transducer (2) comprises a limiting element (23), with the aid of which the diaphragm (13) is limited in the deflection in at least one direction of a reciprocation axis (20) of the sound transducer (2).

6. The sound-generating unit as claimed in one or more of the preceding claims 1 to 5, **characterized in that** the diaphragm (13), in particular separated by the limiting element (23), comprises a first diaphragm area (25) and a second diaphragm area (26), wherein one of the sound transducer units (21, 22) can deflect the diaphragm (13) in the first diaphragm area (25) for sound generation and the other sound transducer unit (21, 22) can detect the deflection of the diaphragm (13) in the second diaphragm area (26) for sound recording.

7. The sound-generating unit as claimed in at least claim 4, **characterized in that** the amplifier unit (1) comprises a processor (4), in particular a digital signal processor, with the aid of which the MEMS sound transducer (2) provided therefor can be utilized as a microphone at the same time as the sound generation and/or the processor (4) is designed, for sound cancellation, in such a way that it can filter out and/or suppress ambient noise on the basis of the emitted audio signal and the acoustic signal detected at the same time with the aid of the same MEMS sound transducer (2).

8. The sound-generating unit as claimed in one or more of the preceding claims 4 to 7, **characterized in that** the processor (4) is designed in such a way that it separates an acoustic signal, which is detected by the MEMS sound transducer (2) operating as a microphone, into a first acoustic signal component representing the emitted useful sounds and into a second acoustic signal component representing the ambient noise and/or the processor (4) is designed in such a way that it generates an anti-noise signal on the basis of the second acoustic signal component and combines the anti-noise signal with an input signal including useful sound to form the audio signal.

9. The sound-generating unit as claimed in one or more of the preceding claims 4 to 8, **characterized in that** the processor (4) is designed in such a way that it can switch the MEMS sound transducer (2) between the operation as a loudspeaker and the operation as a microphone.

10. The sound-generating unit as claimed in one or more of the preceding claims 4 to 9, **characterized in that** the amplifier unit (1) comprises a hybrid audio amplifier (3c), with the aid of which the audio signal can be output to the MEMS sound transducer (2) provided therefor, for sound reproduction, and the acoustic signal of the MEMS sound transducer (2) can be received, for sound recording and/or the amplifier unit (1) comprises a loudspeaker amplifier (3a) for the sound reproduction of the audio signal and a microphone amplifier (3b) for the sound recording of the acoustic signal.

11. The sound-generating unit as claimed in one or more of the preceding claims 1 to 10, **characterized in that** the amplifier unit (1) comprises at least one signal processor (5a, 5b), which is connected to the at least one audio amplifier (3a, 3b) and with the aid of which the audio signal can be preconditioned for sound reproduction and/or the acoustic signal can be conditioned for sound recording.

12. The sound-generating unit as claimed in one or more of the preceding claims 4 to 11, **characterized in that** the processor (4) comprises a data link (11) to the at least one audio amplifier (3a, 3b) and/or to the at least one signal processor (5a, 5b), with the aid of which the emitted audio signals and detected acoustic signals and the audio data to be processed in the signal processor (5a, 5b) can be transmitted to the processor (4) and/or the amplifier unit (1) comprises at least one, in particular wired and/or bidirectional, interface (10), via which audio signals can be transmitted from the amplifier unit (1) to the MEMS sound transducer (2) and acoustic signals can be transmitted from the MEMS sound transducer (2) to the amplifier unit (1), preferably at the same time.

## Revendications

1. Unité de génération acoustique
comprenant un transducteur acoustique MEMS (2) qui peut fonctionner en tant que microphone et en tant que haut-parleur, et
une unité d'amplification (1) couplée au transducteur acoustique MEMS (2) pour la reproduction acoustique et l'enregistrement acoustique, l'unité d'amplification (1) comportant au moins un amplificateur audio (3a, 3b) pour la reproduction acoustique et l'enregistrement acoustique, l'unité d'amplification (1) étant réalisée de telle sorte que le transducteur acoustique MEMS (2) prévu à cet effet puisse fonctionner simultanément en tant que haut-parleur et en tant que microphone, et
l'enregistrement d'acoustique et la génération simultanée d'acoustique pouvant être effectués par un seul transducteur acoustique MEMS (2), **caractérisé en ce que**
le transducteur acoustique MEMS (2) comporte une première et une deuxième unité de transducteur acoustique (21, 22) couplées à un diaphragme (13) du transducteur acoustique MEMS (2), les ondes acoustiques pouvant être générées à l'aide de la première unité de transducteur acoustique (21) et les ondes acoustiques pouvant être enregistrées à l'aide de la deuxième unité de transducteur acoustique (22).

2. Unité de génération acoustique selon la revendication précédente, **caractérisée en ce que** le transducteur acoustique MEMS (2) est réalisé en tant que transducteur acoustique simultané qui peut émettre un signal audio fonctionnant en tant que haut-parleur et enregistrer simultanément un signal acoustique fonctionnant en tant que microphone et/ou **en ce que** le transducteur acoustique MEMS (2) est un transducteur acoustique MEMS piézoélectrique et/ou **en ce que** l'unité d'amplification (1) et le transducteur acoustique MEMS (2) sont disposés sur une seule puce.

3. Unité de génération acoustique selon une ou plusieurs des revendications précédentes 1 à 2, **caractérisée en ce que** les deux unités de transducteur acoustique (21, 22) comportent au moins deux couches de transducteur acoustique (29, 30), le diaphragme (13) pouvant être dé-flectible au moyen d'une couche de transducteur acoustique (29, 30) et la déviation du diaphragme (13) pouvant être détectée au moyen de l'autre couche de transducteur acoustique.

4. Unité de génération acoustique selon une ou plusieurs des revendications précédentes 1 à 3, **caractérisée en ce que** les deux unités de transducteur acoustique (21, 22) et/ou au moins une des deux couches de transducteur acoustique (29, 30) sont connectées à un processeur (4) de l'unité d'amplification (1) de sorte que celui-ci puisse déflectibler le diaphragme (13) pour la génération acoustique au moyen des deux unités de transducteur acoustique (21, 22) et/ou au moins une des deux couches de transducteur acoustique (29, 30) et détecter la déviation pour la détection acoustique.

5. Unité de génération acoustique selon une ou plusieurs des revendications précédentes 1 à 4, **caractérisée en ce que** les au moins deux unités de transducteur acoustique (21, 22) du transducteur acoustique MEMS (2) sont connectées l'une à l'autre au moyen d'un élément de connexion (24), en particulier élastique, et/ou **en ce que** le transducteur acoustique MEMS (2) comporte un élément de limitation (23) par lequel le diaphragme (13) est limité dans la déviation dans au moins une direction d'un axe de levage (20) du transducteur acoustique (2).

6. Unité de génération acoustique selon une ou plusieurs des revendications précédentes 1 à 5, **caractérisée en ce que** le diaphragme (13), en particulier séparé par l'élément de limitation (23), comporte une première zone de diaphragme (25) et une deuxième zone de diaphragme (26), une des unités de transducteur acoustique (21, 22) pouvant déflectibler le diaphragme (13) dans la première zone de diaphragme (25) pour la génération acoustique et l'autre unité de transducteur acoustique (21, 22) pouvant détecter la déviation du diaphragme (13) dans la deuxième zone de diaphragme (26) pour la détection acoustique.

7. Unité de génération acoustique selon au moins la revendication 4, **caractérisée en ce que** l'unité d'amplification (1) comporte le processeur (4), en particulier un processeur de signal digital, au moyen duquel le transducteur acoustique MEMS (2) prévu à cet effet peut être utilisé simultanément en tant que microphone pendant la génération acoustique et/ou **en ce que** le processeur (4) est réalisé pour la suppression du bruit de telle sorte que celui-ci puisse filtrer et/ou supprimer les bruits ambiants à l'aide d'un signal audio émis et d'un signal acoustique détecté simultanément avec le même transducteur acoustique MEMS (2).

8. Unité de génération acoustique selon une des revendications précédentes 4 à 7, **caractérisée en ce que** le processeur (4) est réalisé de telle sorte que celui-ci sépare un signal acoustique qui est détecté par le transducteur acoustique MEMS (2) fonctionnant en tant que microphone en une première partie de signal acoustique représentant les bruits utiles émis et une deuxième partie de signal acoustique représentant les bruits ambiants, et/ou **en ce que** le processeur (4) est réalisé de telle sorte que celui-ci génère un signal antisonore à l'aide de la deuxième partie de signal acoustique et combine celui-ci avec un signal d'entrée comprenant des bruits utiles en signal audio.

9. Unité de génération acoustique selon une ou plusieurs des revendications précédentes 4 à 8, **caractérisée en ce que** le processeur (4) est réalisé de telle sorte que celui-ci puisse commuter le transducteur acoustique MEMS (2) entre le fonctionnement en tant que haut-parleur et le fonctionnement en tant que microphone.

10. Unité de génération acoustique selon une ou plusieurs des revendications précédentes 1 à 9, **caractérisée en ce que** l'unité d'amplification (1) comporte un amplificateur audio hybride (3c) au moyen duquel le signal audio peut être émis au transducteur acoustique MEMS (2) prévu à cet effet pour la reproduction acoustique et le signal acoustique du transducteur acoustique MEMS (2) peut être reçu pour l'enregistrement acoustique et/ou **en ce que** l'unité d'amplification (1) comporte un amplificateur de haut-parleur (3a) pour la reproduction acoustique du signal audio et un amplificateur de microphone (3b) pour l'enregistrement acoustique du signal acoustique.

11. Unité de génération acoustique selon une ou plusieurs des revendications précédentes 1 à 10, **caractérisée en ce que** l'unité d'amplification (1) comporte au moins une unité de traitement de signal (5a, 5b) qui est connectée à l'au moins un amplificateur audio (3a, 3b) et au moyen de laquelle le signal audio peut être préparé pour la reproduction acoustique et/ou le signal acoustique peut être préparé pour l'enregistrement acoustique.

12. Unité de génération acoustique selon une ou plusieurs des revendications précédentes 4 à 11, **caractérisée en ce que** le processeur (4) comporte une liaison de données (11) avec l'au moins un amplificateur audio (3a, 3b) et/ou avec l'au moins une unité de traitement de signal (5a, 5b), par le biais de laquelle les signaux audio émis et les signaux acoustiques détectés et les données audio à traiter dans l'unité de traitement de signal (5a, 5b) peuvent être transmis au processeur (4), et/ou **en ce que** l'unité d'amplification (1) comporte au moins une interface (10), en particulier câblée et/ou bidirectionnelle, par le biais de laquelle de préférence simultanément des signaux audio peuvent être transmis de l'unité d'amplification (1) au transducteur acoustique MEMS (2) et des signaux acoustiques peuvent être transmis de celui-ci à l'unité d'amplification (1).
